# EUROPEAN PATENT APPLICATION

(11) **EP 3 024 147 A1**
(43) Date of publication of application: **25.05.2016**
(21) Application number: 14306827.8
(22) Date of filing: 18.11.2014
(51) Int. Cl.: H03M 7/30, H03M 3/00

(54) **Apparatuses, receiver module, transmitter module, analog-digital converter, methods and computer programs for providing a delta-sigma-modulated signal**

(71) Applicant: ALCATEL LUCENT, 92100 Boulogne-Billancourt (FR)
(72) Inventor: Yu, Xin, 70435 Stuttgart (DE); Haslach, Christoph, 70435 Stuttgart (DE)
(74) Representative: 2SPL Patentanwälte PartG mbB

(57) **Abstract**

Embodiments relate to an apparatus (10), a receiver module (100), a transmitter module (200), an analog-digital converter (300), methods and computer programs for providing a delta-sigma-modulated signal, based on an input signal. The apparatus comprises a combination module (12) to dynamically select the input signal or a combined signal as selected signal, wherein the combined signal is based on a combination of the input signal, a feedback signal, and a reference signal and a processing module (14) to provide the delta-sigma modulated signal representing a quantized selected signal based on the selected signal, and to provide the feedback signal based on the selected signal.

## Description

### Technical Field

Embodiments relate to apparatuses, a receiver module, a transmitter module, an analog-digital converter, methods and computer programs for providing a delta-sigma-modulated signal, particularly, but not exclusively based on a quantized signal based on a selection between an input signal and combined input, feedback and reference signals.

### Background

This section introduces aspects that may be helpful in facilitating a better understanding of the invention(s). Accordingly, the statements of this section are to be read in this light and are not to be understood as admissions about what is in the prior art or what is not in the prior art.

Current communication systems may often struggle to meet the demand for fast and reliable data transmissions. In recent years, data-intensive content, such as streaming video, digital software distribution, online data storage or smartphone mobile data have greatly increased the amount of data transmitted in wired and wireless communication systems. To increase the capacity of the communications systems, faster and more efficient transceivers may improve the data transmission rates and increase the energy efficiency at the same time. An integration of previously analog functionality into digital circuitry may allow the use of more advanced signal processing to allow for using more energy efficient hardware as well as getting higher data rates.

Transceiver modules, which comprise transmitter modules and receiver modules based on all digital concept using switch mode amplification, may often comprise Delta-Sigma-Modulators (DSM, also ΔΣ-Modulators) for signal processing. DSMs may be used to convert(sample) an analog or digital signal with a sampling frequency, using a delta modulation, and quantize the signal into a digital signal. For digital signal to digital signal conversion a DSM may convert a digital signal with high resolution to a digital signal with low resolution. The difference between the analog or digital DSM input signal and the digital DSM output signal, which may correspond to a quantization error, might be fed back and be used to reduce the error introduced by the delta modulation.

Delta-Sigma-Modulators implicitly use Infinite-Impulse-Response (IIR) filters on the quantization noise by providing the feedback signals. IIR filters are filters using an impulse response which continues indefinitely without becoming zero. Such IIR filters may often be implemented using analog circuitry, such as resistors and capacitors, which may have an intrinsic "memory" representing the infinite impulse response, or digital circuitry, such as connected registers with feedback loops in between.

### Summary of illustrative Embodiments

Some simplifications may be made in the following summary, which is intended to highlight and introduce some aspects of the various exemplary embodiments, but such simplifications are not intended to limit the scope of the invention(s). Detailed descriptions of a preferred exemplary embodiment adequate to allow those of ordinary skill in the art to make and use the inventive concepts will follow in later sections.

Various embodiments provide apparatuses, a receiver module, a transmitter module, an analog-digital converter, methods and computer programs for providing a delta-sigma-modulated signal. To provide delta-sigma-modulation for high-speed applications, a number of approaches may be considered. To lower integration costs, implementations of delta-sigma-modulators based on digital circuitry might be used, so such modules may be conveniently integrated, e.g. by using modules provided as digital Intellectual Property (IP) modules by a third-party hardware developer. To allow for higher target frequencies, a parallelization of signal processing tasks, running at a lower processing frequency might be used.

Embodiments provide an apparatus for providing a delta-sigma-modulated signal, based on an input signal. The apparatus comprises a combination module to dynamically select the input signal or a combined signal as selected signal, wherein the combined signal is based on a combination of the input signal, a feedback signal, and a reference signal. The apparatus further comprises a processing module to provide the delta-sigma modulated signal or index signal representing a quantized selected signal based on the selected signal, and to provide the feedback signal based on the selected signal. By dynamically selecting the combined signal or the input signal, in embodiments, the feedback loop may be reset or modified, which may allow a fully digital implementation.

In some embodiments, the apparatus may further comprise one or more additional combination modules corresponding to the combination module, and a selected signal of one of the one or more additional combination modules may be used as input for a subsequent combination module. In various embodiments further comprising one or more additional combination modules corresponding to the combination module, a selected signal of one of the one or more additional combination modules may be used as input for a subsequent combination module, the additional combination modules may be configured to dynamically select the input signal or an additional combined signal, the additional combined signal may further be based on an additional feedback signal, and the combination module may be configured to provide the additional feedback signal to one of the one or more additional combination modules. By using multiple combination modules, embodiments may provide a multi-stage DSM.

In various embodiments, the combination module may comprise a switch configured to switch an input of the processing module for the selected signal between an input for the input signal and the combined signal. In some embodiments, the combination module may further comprise a buffer to store the selected signal and to provide the selected signal as previous selected signal subsequently. The reference signal may, in embodiments, correspond to a previously selected signal, a constant value or a reset value. By dynamically selecting the combined signal or the input signal, in embodiments, the feedback loop may be reset, which may allow a fully digital implementation. In embodiments, a buffer, which may correspond to a register, may be used to allow the signal to be used in subsequent clock cycles. In some embodiments, by using a constant value or a reset value for the reference signal, the feedback loop may be broken.

In some embodiments, the apparatus may further comprise a control module. The control module may be configured to control the combination module. The control module may further be configured to determine information related to the selection for the combination module. By changing the frequency of a change of the selection, the control module may, in embodiments, adjust an accuracy of the apparatus.

In some embodiments, the combination of the input signal, the feedback signal and the reference signal of the combination module may correspond to a weighted combination, and the control module may be further configured to determine information related to a weighting of the weighted combination. By using a weighting factor, in embodiments, a generic feedback signal might be used. In some embodiments, a state of the apparatus may be based on a previous selected signal and the feedback signal, and the control module may be configured to perform an iteration on the state of the apparatus, starting with an initial state, wherein the initial state corresponds to selecting the input signal, a constant value or a dynamical value as the selected signal. In some embodiments, the control module may be further configured to select the combined signal as the selected signal until an end of the iteration, wherein the end of the iteration may be based on an integer number of iteration cycles.

In various embodiments, the input signal may comprise a plurality of blocks of samples. In some embodiments, the control module may be configured to determine the information related to the selection for the combination module based on information related to a number of samples in a block of the input signal. The control module might also be configured to determine the information related to the selection for the combination module based on information related to a number of processed samples since a last change of the selection for the combination module. In various embodiments, the control module may also be configured to determine the selection for the combination module such that the input signal is selected as selected signal at least once within a block of samples. In embodiments, the control module may also be configured to determine the information related to the selection for the combination module based on a performance requirement. By basing the selection for the combination module on the number of samples, in embodiments, the apparatus might be reset at the beginning of each block of samples.

In embodiments, the processing module may comprise a quantization module. In various embodiments, the processing module might comprise a Look-Up Table (LUT) which may be configured to assign samples of the delta-sigma-modulated signal to samples of the selected signal. The selected signal may, in embodiments, correspond to a sequence of signal pulses or a pre-defined signal pattern. Using a LUT, embodiments might quantize the selected signal within a clock cycle.

Embodiments further provide an apparatus for processing a sampled signal with a primary sampling rate. The apparatus comprises a demultiplexing module to provide a first input signal with a first sampling rate, and a second input signal with a second sampling rate. The first and second sampling rates are lower than the primary sampling rate, and the first and second input signals are based on the sampled signal. The apparatus further comprises a first apparatus for providing a delta-sigma-modulated signal, to process the first input signal to provide a first delta-sigma-modulated signal. The apparatus further comprises a second apparatus for providing a delta-sigma-modulated signal, to process the second input signal to provide a second delta-sigma-modulated signal. By using multiple apparatuses for providing a delta-sigma-modulated signal in parallel, embodiments might enable the processing of the sampled signal at a fraction of the frequency of the sampled signal.

In some embodiments, the demultiplexing module may further provide the first and second input signals as block-wise demultiplexed signals. In various embodiments, the apparatus might further comprise a first and second input sample buffer to buffer the first and second input signals. In some embodiments, the apparatus might further comprise a first and a second output sample buffer to buffer the two or more delta-sigma-modulated signals. In some embodiment, the apparatus may further comprise a multiplexing module to provide a multiplexed signal, based on the first and second delta-sigma-modulated signals. In some embodiments, the demultiplexing module and/or the multiplexing module may comprise a buffer for storing the first or second input signals and/or the first and second delta-sigma-modulated signals. Using buffers, the sampled signal might be demultiplexed and stored for the first and second apparatus for providing a delta-sigma-modulated signal, so the signal, as first and second input signal, may be accessed at a lower speed, which may decrease the operating frequency necessary for the first and second apparatus for providing a delta-sigma-modulated signal.

In some embodiments, the apparatus may further comprise a pulse modulator to provide a pulse modulated signal based on the multiplexed signal. The pulse modulator might, in embodiments, prepare the multiplexed signal for a wireless transmission.

In various embodiments, the pulse modulator may comprise a Pulse Width Modulator (PWM). In some embodiments, the pulse modulator may comprise a Pulse Position Modulator (PPM). The PWM and/or the PPM might, in embodiments, prepare the multiplexed signal for a wireless transmission.

Embodiments further provide a receiver module, a transmitter module, and/or an Analog-Digital Converter (ADC) comprising an apparatus for providing a delta-sigma-modulated signal and/or an apparatus for processing a sampled signal with a primary sampling rate. In a receiver module, a transmitter module or an ADC, embodiments of an apparatus for providing a delta-sigma-modulated signal may provide an increased Signal to Noise Ratio (SNR). An apparatus for processing a sampled signal with a primary sampling rate may, in embodiments, allow the receiver module, the transmitter module, and/or the ADC, to partially operate at lower frequencies.

Embodiments further provide a method for providing a delta-sigma-modulated signal, based on an input signal. The method comprises selecting the input signal or a combined signal as selected signal, wherein the combined signal is based on a combination of the input signal, a feedback signal, and a reference signal. The method further comprises providing the delta-sigma modulated signal representing a quantized selected signal based on a selected signal, and providing the feedback signal based on the selected signal.

Embodiments further provide a method for processing a sampled signal with a primary sampling rate. The method comprises providing a first input signal with a first sampling rate and a second input signal with a second sampling rate, wherein the first and second sampling rates are lower than the primary sampling rate, and wherein the first and second input signals are based on the sampled signal. The method further comprises processing the first input signal to provide a first delta-sigma-modulated signal, and processing the second input signal to provide a second delta-sigma-modulated signal.

Embodiments further provide a computer program having a program code for performing at least one of the above methods, when the computer program is executed on a computer, a processor, or a programmable hardware component. A further embodiment is a computer readable storage medium storing instructions which, when executed by a computer, processor, or programmable hardware component, cause the computer to implement one of the methods described herein.

### Brief description of the figures

Some other features or aspects will be described using the following non-limiting embodiments of apparatuses or methods or computer programs or computer program products by way of example only, and with reference to the accompanying figures, in which:
Fig. 1 illustrates a block diagram of an embodiment of an apparatus for providing a delta-sigma-modulated signal;
Fig. 2 shows a block diagram of a Delta Sigma Modulator, Pulse Width Modulation and Pulse Position Modulation based transmitter architecture;
Fig. 3 shows a block diagram of a first order Delta Sigma Modulator;
Fig. 4 shows a block diagram of a time-interleaved Delta Sigma Modulator;
Fig. 5 illustrates a more detailed block diagram of an embodiment of an apparatus for providing a delta-sigma-modulated signal;
Fig. 6 illustrates a block diagram of an embodiment of an apparatus for providing a delta-sigma-modulated signal with one or more additional combination modules;
Fig. 7 illustrates a block diagram of an embodiment of an apparatus for processing a sampled signal with a primary sampling rate;
Fig. 8 illustrates a block diagram of an embodiment of a scalable Delta Sigma Modulator with a reset function;
Fig. 9 shows a plot of a Matlab simulation showing a performance comparison of embodiments;
Fig. 10 shows a plot of a Matlab simulation showing a wideband spectrum comparison of embodiments;
Fig. 11 illustrates a block diagram of an embodiment of a 4-fold parallel scalable DSM;
Fig. 12 illustrates a block diagram of an embodiment of a receiver module comprising an apparatus for providing a delta-sigma-modulated signal and/or an apparatus for processing a sampled signal with a primary sampling rate;
Fig. 13 illustrates a block diagram of an embodiment of a transmitter module comprising an apparatus for providing a delta-sigma-modulated signal and/or an apparatus for processing a sampled signal with a primary sampling rate;
Fig. 14 illustrates a block diagram of an embodiment of an analog-digital converter comprising an apparatus for providing a delta-sigma-modulated signal and/or an apparatus for processing a sampled signal with a primary sampling rate;
Fig. 15 shows a block diagram of a flow chart of an embodiment of a method for providing a delta-sigma-modulated signal; and
Fig. 16 shows a block diagram of a flow chart of an embodiment of a method for processing a sampled signal with a primary sampling rate.

### Description of Embodiments

Various example embodiments will now be described more fully with reference to the accompanying drawings in which some example embodiments are illustrated. In the figures, the thicknesses of lines, layers or regions may be exaggerated for clarity. Optional components may be illustrated using broken, dashed or dotted lines.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

As used herein, the term, "or" refers to a non-exclusive or, unless otherwise indicated (e.g., "or else" or "or in the alternative"). Furthermore, as used herein, words used to describe a relationship between elements should be broadly construed to include a direct relationship or the presence of intervening elements unless otherwise indicated. For example, when an element is referred to as being "connected" or "coupled" to another element, the element may be directly connected or coupled to the other element or intervening elements may be present. In contrast, when an element is referred to as being "directly connected" or "directly coupled" to another element, there are no intervening elements present. Similarly, words such as "between", "adjacent", and the like should be interpreted in a like fashion.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" or "including," when used herein, specify the presence of stated features, integers, steps, operations, elements or components, but do not preclude the presence or addition of one or more other features, integers, steps, operations, elements, components or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

Existing wireless communication network deployed around the world may struggle to meet the growing demand for fast and robust wireless data transmissions that's due to the rise of smartphones and tables. Consequently, next generation wireless transceivers may employ innovative technologies, such as fully digital transceiver architectures, to effectively pave the wave for future wireless applications.

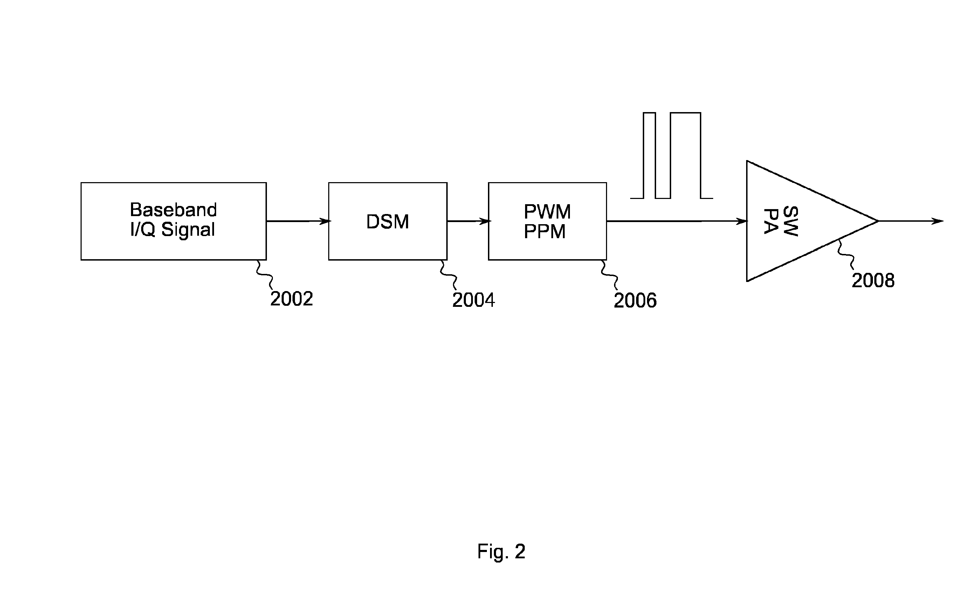

A Delta Sigma Modulator (DSM) 2004, Pulse Width Modulation (PWM) and Pulse Position Modulation (PPM) 2006 based transmitter architecture, as shown in Fig. 2, may, in embodiments, be seen as a promising fully digital transmitter architecture. Fig. 2 further shows a baseband In-phase component/Quadrature component (I/Q) signal 2002 and a switch-mode power amplifier 2008.

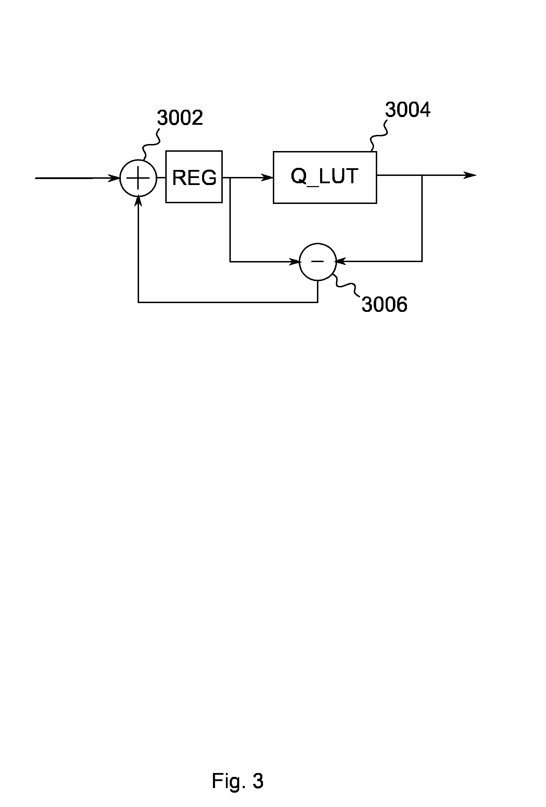

Fig. 3 shows a first order DSM comprising a combination module 3002 with a corresponding register, a quantization module 3004, and a combination module 3006 to generate the feedback signal. Generally, in a fully digital transmitter, a DSM may run at the carrier frequency of the Radio Frequency (RF) signal due to requirements on signal bandwidth and signal integrity. In such cases, a DSM may operate at multiple GHz and all the arithmetic operations as well as memory accesses may have to be done within one clock cycle of the DSM operating frequency, which may present a technical challenge for hardware implementation. The performance of a conventional Field Programmable Gate Array (FPGA) might be far away from what such operating frequencies. Even as an Application Specific Integrated Circuit (ASIC), a DSM may be considered difficult to implement with good quantization resolution. Furthermore, to improve the performance of a DSM additional signal processing may be introduced in the DSM, which may raise the implementation difficulty. As the Noise Transfer Function (NTF) of a DSM may be constructed using an IIR filter with nonlinear operations, a parallelization of a DSM may result in a huge performance degradation. In embodiments, a DSM may comprise an additional reset function to scale the number of sample segment, which may be operated as a unit. Based on such a scalable DSM, the DSM procedure might be parallelized by a factor, and hence might reduce the DSM operating frequency by the same factor. A parallel scalable DSM structure might be implemented in an FPGA.

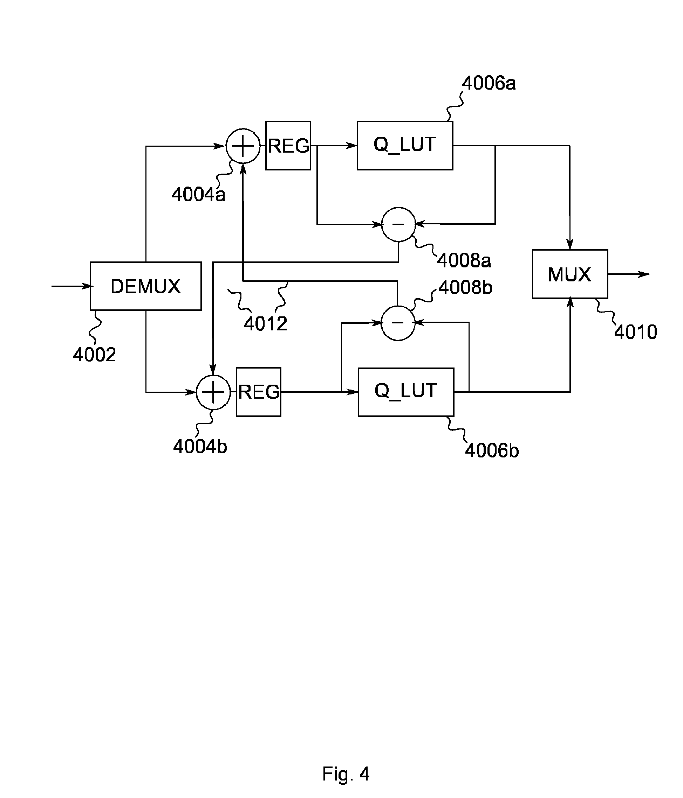

Fig. 4 shows a block diagram of a time interleaved DSM comprising a demultiplexing module 4002, two combination modules 4004a, 4004b with corresponding registers, two quantization modules 4006a, 4006b, two comparison modules 4008a, 4008b to generate the feedback signal, and a multiplexing module 4010. However, the quantization error 4012 may be interleaved between two parallel DSMs as well. Therefore, the DSM operating frequency might not be reduced because the quantization error may be processed at the data rate before the DEMUX module. If the quantization error between the DSMs is not interleaved between the DSMs, the DSM performance including bandwidth and filtering of quantization noise may be reduced.

Due to progress in developing PWMs and PPMs, the resolution of PWMs and PPMs may have improved. The quantization noise of PPMs and PWMs might be reduced due to a finer resolution. Therefore, PWMs and PPMs might reach a Signal to Noise Ratio (SNR) 30dB or more, depending on signal properties. Therefore, a performance requirement on the DSM in terms of suppressing quantization noise in frequency bands of interest might be relieved. Embodiments may break the NTF filter by a "reset" function or a bypass function in the DSM, so the DSM may be parallelized, with benefits regarding hardware implementation.

Embodiments may apply parallel DSM processing of consecutive signal segments. In Embodiments, a degradation of a performance of the DSM may be moderate. In some embodiments, the degradation may become negligible for many scenarios using first order DSM.s

A parallel processing of the consecutive signal segments may allow for implementing the DSM with technologies that might be significantly slower than an operating frequency required in a conventional DSM.

Furthermore, parallel processing may allow to add additional processing in the feedback path of the DSM, employment of larger lookup tables etc., because a parallel implementation may allow to relax timing constraints of the critical feedback loop in compared to non-parallel DSM implementations.

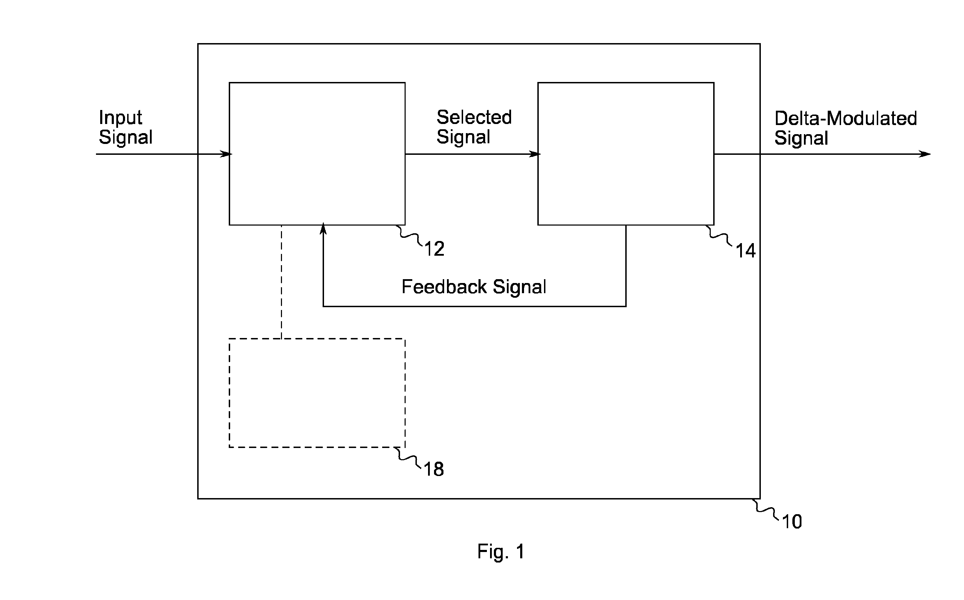

In the following, some embodiments for apparatuses, a receiver module, a transmitter module, an analog-digital converter, methods and computer programs for providing a delta-sigma-modulated signal will be introduced. Fig. 1 illustrates a block diagram of an embodiment of an apparatus 10 for providing a delta-sigma-modulated signal, comprising a combination module 12 and a processing module 14. In some embodiments, the apparatus 10 further comprises a control module 18. The combination module 12 receives an input signal, and is coupled to the processing module 14 and, in some embodiments, to the control module 18.

The apparatus 10 is configured to provide a delta-sigma-modulated signal, based on an input signal.

A delta-sigma-modulated signal may, in embodiments, correspond to a digital signal converted from an analog or digital signal, wherein the analog or digital signal is first delta-modulated, which may result in a stream of pulses corresponding to the analog or digital signal, and then quantized, wherein the difference between the quantized signal and the input signal or the quantized signal and the delta-modulated signal may be used to reduce a quantization error resulting from the delta modulation. A delta-modulated signal may, in embodiments, correspond to quantized signal or a stream of pulses after using PWM/PPM modulation, which may be based on an integration of the change (delta) of an input signal.

The apparatus 10 comprises a combination module 12 to dynamically select the input signal or a combined signal as selected signal, wherein the combined signal is based on a combination of the input signal, a feedback signal, and a reference signal.

In embodiments, the combination module 12 may be implemented using one or more processing units, one or more processing devices, any means for processing, such as a processor, a computer or a programmable hardware component being operable with accordingly adapted software. In other words, the described functions of the combination module 12 may as well be implemented in software, which is then executed on one or more programmable hardware components. Such hardware components may comprise a general purpose processor, a Digital Signal Processor (DSP), a micro-controller, a Field Programmable Gate Array (FPGA), a Programmable Logic Device, a Programmable Array Logic (PAL) etc. In embodiments, the combination module 12 may also be implemented using one or more Application Specific Integrated Circuits (ASIC).

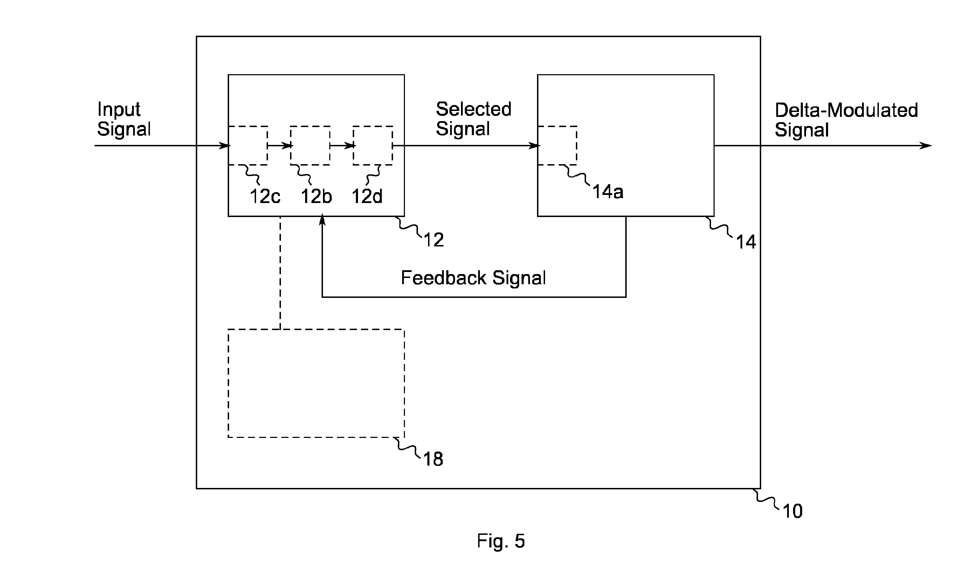

Fig. 5 illustrates a block diagram of an embodiment of an apparatus 10. In some embodiments, as shown in Fig. 5, the combination module 12 may comprise a switch 12b configured to switch an input 14a of the processing module 14 for the selected signal between an input 12c for the input signal, and the combined signal. In embodiments, the switch 12b may correspond to a multiplexer multiplexing the input signal and the combined signal.

In some embodiments the combination module 12 may further comprise a buffer 12d to store the selected signal and to provide the selected signal as previous selected signal subsequently. In embodiments the buffer 12d may correspond to any data buffer, e.g. a memory for at least temporarily storing data, such as, for example, a register, a flip-flop, , a programmable gate, Random Access Memory (RAM), non-volatile storage, and flash memory. In some embodiments, the reference signal may correspond to a previously selected signal, a constant value or a reset value. A constant value may correspond to a constant digital bit value or an analog voltage. A reset value may correspond to a digital bit value or an analog voltage, which may be used to reset the feedback loop to an initial state. In embodiments, a reset signal may also correspond to a negative feedback signal.

The apparatus 10 further comprises a processing module 14 to provide the delta-sigma modulated signal representing a quantized selected signal based on the selected signal, and to provide the feedback signal based on the selected signal.

In embodiments, the processing module 14 may be implemented using one or more processing units, one or more processing devices, any means for processing, such as a processor, a computer or a programmable hardware component being operable with accordingly adapted software. In other words, the described functions of the processing module 14 may as well be implemented in software, which is then executed on one or more programmable hardware components. Such hardware components may comprise a general purpose processor, a Digital Signal Processor (DSP), a micro-controller, a Field Programmable Gate Array (FPGA), a Programmable Logic Device (PLD), a Programmable Array Logic (PAL) etc. In embodiments, the processing module 14 may also be implemented using or in one or more Application Specific Integrated Circuits (ASIC).

In some embodiments, the processing module may further comprise a Look-Up Table, LUT, which may be configured to assign samples of the delta-sigma-modulated signal to samples of the selected signal. In some embodiments, the selected signal may correspond to a sequence of signal pulses or a pre-defined signal pattern.

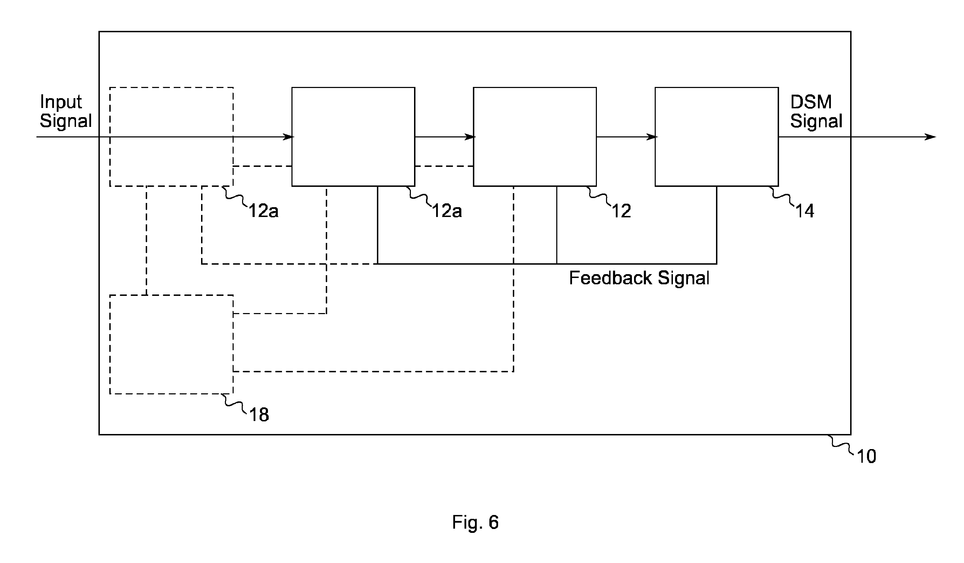

Fig. 6 illustrates a block diagram of an embodiment of an apparatus 10 further comprising one or more additional combination modules 12a corresponding to the combination module 12, wherein a selected signal of one of the one or more additional combination modules 12a may be used as input for a subsequent combination module 12, 12a. In embodiments, the combination modules 12, 12a are coupled to the processing module 14 and to the previous and subsequent combination modules 12,12a. In some embodiments, the combination modules 12, 12a are further coupled to a control module 18.

In some embodiments, the apparatus 10 may further comprise one or more additional combination modules 12a corresponding to the combination module 12, wherein a selected signal of one of the one or more additional combination modules 12a may be used as input for a subsequent combination module 12, 12a. In some embodiments the one or more additional combination modules 12a may be configured to dynamically select the input signal or an additional combined signal, wherein the additional combined signal may further be based on an additional feedback signal. In various embodiments, the combination module 12 may be configured to provide the additional feedback signal to one of the additional combination modules 12a.

In some embodiments, the apparatus 10 may further comprise a control module 18, as shown in Fig. 1, Fig. 5 and Fig. 6. The control module 18 may be configured to control the combination module 12. The control module 18 may further be configured to determine information related to the selection for the combination module 12.

In embodiments, the control module 18 may be implemented using one or more processing units, one or more processing devices, any means for processing, such as a processor, a computer or a programmable hardware component being operable with accordingly adapted software. In other words, the described functions of the control module 18 may as well be implemented in software, which is then executed on one or more programmable hardware components. Such hardware components may comprise a general purpose processor, a Digital Signal Processor (DSP), a micro-controller, a Field Programmable Gate Array (FPGA), a Programmable Logic Device (PLD), a Programmable Array Logic (PAL) etc. In embodiments, the control module 18 may also be implemented using or in one or more Application Specific Integrated Circuits (ASIC).

In some embodiments, the combination of the input signal, the feedback signal and the reference signal of the combination module 12 may correspond to a weighted combination. In some embodiments, the control module 18 may be further configured to determine information related to a weighting of the weighted combination. In embodiments, the weighting of the weighted combination may be based on at least one element of the group of a scaling factor, a normalization value, a selection for the combination module, a position of the combination module 12, 12a in a sequence of combination modules 12,12a etc.

In various embodiments, a state of the apparatus 10 may be based on a previous selected signal and the feedback signal, and the control module 18 may be configured to perform an iteration on the state of the apparatus 10, starting with an initial state, wherein the initial state corresponds to selecting the input signal, a constant value or a dynamical value as the selected signal. The control module 18 may be further configured to select the combined signal as the selected signal until an end of the iteration, wherein the end of the iteration may be based on an integer number of iteration cycles.

In some embodiments, the iteration on the state of the apparatus 10 may be based on an algorithm or method, wherein DSM_state may correspond to the state of the apparatus 10, a state of the combination module, or a state of the processing module and wherein y(n) may correspond to the delta-sigma modulated signal.
If n mod *M ∈* 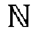 = 0
DSM_state(n) = DSM_state(initial);
Else
DSM_state(n)=f0(input_sig(n-1),DSM_state(n-1));
End
y(n) = f1(input_sig(n-N), DSM_state(n-1));

In some embodiments, the input signal may comprise a plurality of blocks of samples. The control module 18 may be configured to determine the information related to the selection for the combination module 12 based on information related to a number of samples in a block of the input signal. The control module 18 may also be configured to determine the information related to the selection for the combination module 12 based on information related to a number of processed samples since a last change of the selection for the combination module 12. In some embodiments, the control module 18 may also be configured to determine the selection for the combination module 12 such that the input signal is selected as selected signal at least once within a block of samples. In various embodiments, the control module 18 may be configured to determine the information related to the selection for the combination module 12 based on a performance requirement. In embodiments, a performance requirement may correspond to a desired accuracy of the apparatus 10, a desired reaction time of the apparatus 10, a desired delay etc.

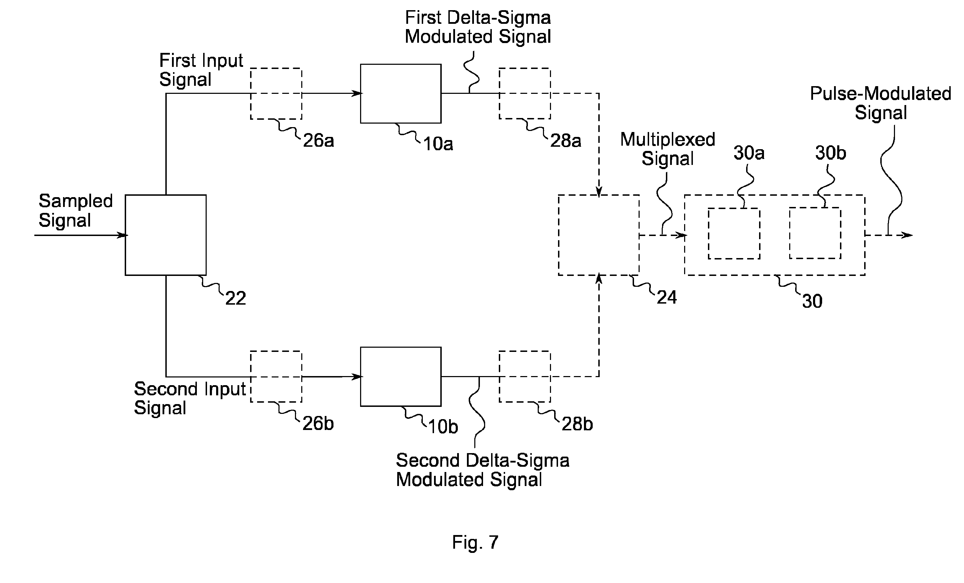

Fig. 7 illustrates a block diagram of an embodiment of an apparatus 20 for processing a sampled signal with a primary sampling rate. The apparatus comprises a demultiplexing module 22 to provide a first input signal with a first sampling rate, and a second input signal with a second sampling rate, wherein the first and second sampling rates are lower than the primary sampling rate, and wherein the first and second input signals are based on the sampled signal.

In embodiments, a demultiplexing module may correspond to a module comprising one input and multiple outputs, wherein the input is forwarded to one of the outputs, based on a selection criteria. In some embodiments the demultiplexing module 22 may further provide the first and second input signals as block-wise demultiplexed signals, for example by choosing a different output after a pre-determined number of samples.

In embodiments, the demultiplexing module 22 may be implemented using one or more processing units, one or more processing devices, any means for processing, such as a processor, a computer or a programmable hardware component being operable with accordingly adapted software. In other words, the described functions of the demultiplexing module 22 may as well be implemented in software, which is then executed on one or more programmable hardware components. Such hardware components may comprise a general purpose processor, a Digital Signal Processor (DSP), a micro-controller, a Field Programmable Gate Array (FPGA), a Programmable Logic Device (PLD), a Programmable Array Logic (PAL) etc. In embodiments, the demultiplexing module 22 may also be implemented using or in one or more Application Specific Integrated Circuits (ASIC).

The apparatus 20 further comprises a first apparatus 10a in line with the above description of the apparatus 10, to process the first input signal to provide a first delta-sigma-modulated signal and a second apparatus 10b in line with the above description of the apparatus 10, to process the second input signal to provide a second delta-sigma-modulated signal.

In some embodiments, the apparatus 20 may further comprise a first and second input sample buffer 26a, 26b to buffer the first and second input signals. In various embodiments the apparatus 20 may also comprise a first and a second output sample buffer 28a, 28b to buffer the two or more delta-sigma-modulated signals.

In some embodiments, the apparatus 20 may further comprise a multiplexing module 24 to provide a multiplexed signal, based on the first and second delta-sigma-modulated signals.

In embodiments, a multiplexing module may correspond to a module comprising one output and multiple inputs, wherein one of the multiple inputs is selected and forwarded to the output, based on a selection criteria.

In embodiments, the multiplexing module 24 may be implemented using one or more processing units, one or more processing devices, any means for processing, such as a processor, a computer or a programmable hardware component being operable with accordingly adapted software. In other words, the described functions of the multiplexing module 24 may as well be implemented in software, which is then executed on one or more programmable hardware components. Such hardware components may comprise a general purpose processor, a Digital Signal Processor (DSP), a micro-controller, a Field Programmable Gate Array (FPGA), a Programmable Logic Device (PLD), a Programmable Array Logic (PAL) etc. In embodiments, the multiplexing module 24 may also be implemented using or in one or more Application Specific Integrated Circuits (ASIC).

In various embodiments, the demultiplexing module 22 and/or the multiplexing module 24 may comprise a buffer for storing the first or second input signals and/or the first and second delta-sigma-modulated signals.

In embodiments a buffer may correspond to any data buffer, e.g. a memory for at least temporarily storing data, such as, for example, a fifo, a register, a flip-flop, a programmable gate, Random Access Memory (RAM), non-volatile storage, and flash memory.

In some embodiments, the apparatus 20 may further comprise a pulse modulator 30 to provide a pulse modulated signal based on the multiplexed signal. In various embodiments, the pulse modulator 30 may comprise a Pulse Width Modulator (PWM) 30a and/or a Pulse Position Modulator (PPM) 30b.

As illustrated in Fig. 7, the demultiplexing module 22 is coupled to the first and second apparatuses 10a and 10b, optionally via the 26a and 26b. In some embodiment, the first and second apparatuses 10a and 10b may be coupled to the multiplexing module 24, optionally via the buffers 28a and 28b. In some embodiments, the multiplexing module 24 may be coupled to the pulse modulator 30. In various embodiments, the PWM 30a may be coupled to the PWM 30b

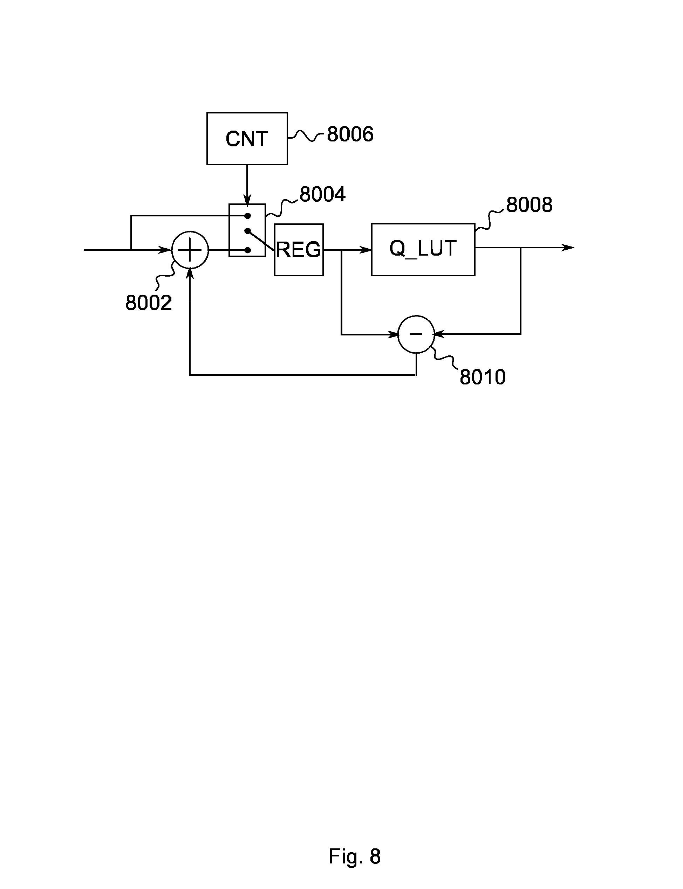

Fig. 8 illustrates a block diagram of an embodiment of a scalable first DSM with a reset function, comprising a combination module 8002, a switch 8004, a counter 8006, a quantization module 8008, and a comparison module. The combination module 8002 is coupled to an input signal and, through a combined signal, to the comparison module 8010. The switch 8004 is coupled to the input signal, the combined signal from the combination module 8002, and to the counter 8006. The switch 8004 may provide a selected signal for the quantization module 8008, and the comparison module 8010. In embodiments, the selected signal may be buffered by a register. The comparison module 8010 may further obtain the delta-modulated signal from the quantization module 8008. In embodiments of a scalable DSM, the quantization error may be reset cyclically after an arbitrary number of samples. In embodiments, a reset may be performed by bypassing the quantization error feedback by using a switch 8004 after an arbitrary number of samples, controlled by a counter 8006. In embodiments, the quantization module 8008 may correspond to the processing module 14, the counter 8006 may correspond to the control module 18, and the switch 8004, the combination module 8002 and the comparison module,8010 may correspond to the combination module 12.

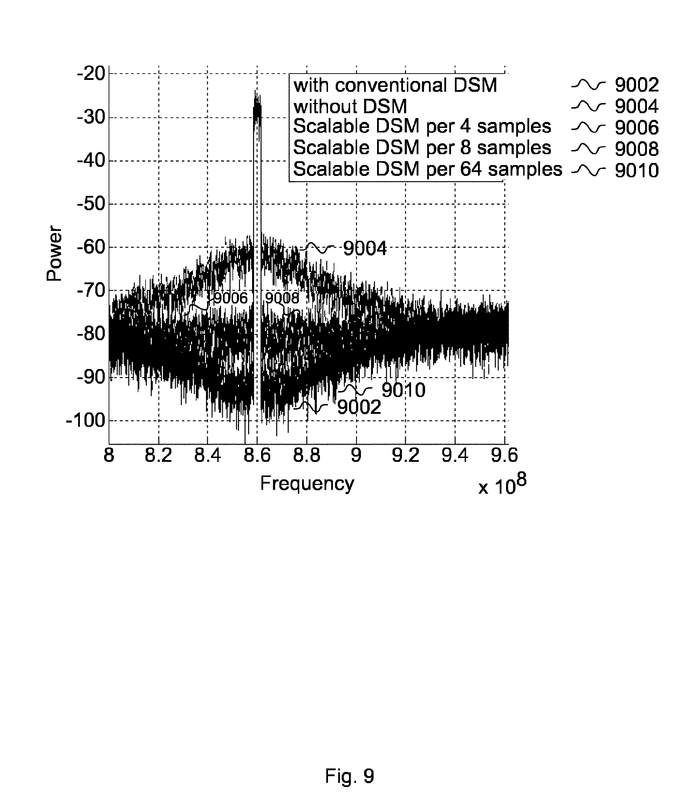

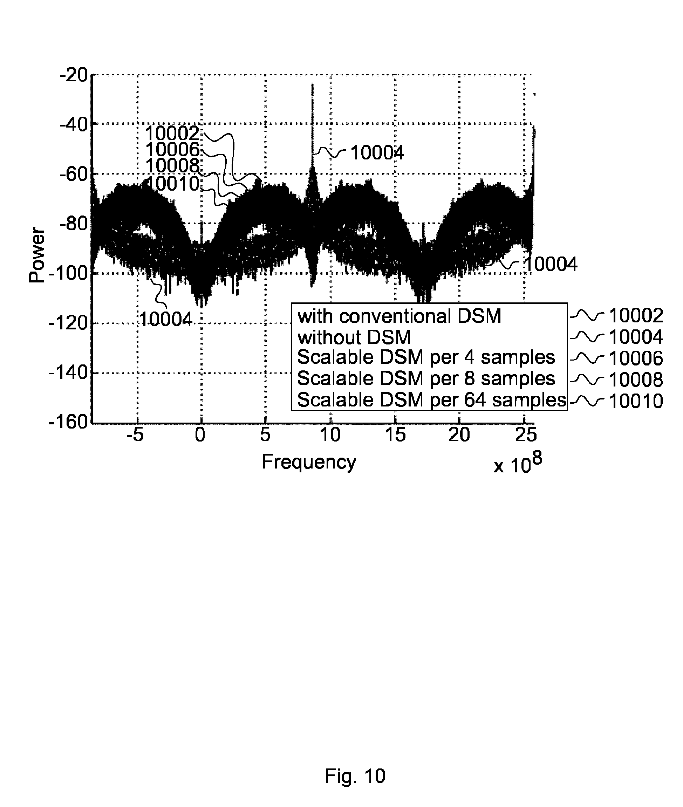

By using the switch 8004, the IIR filter, which may supply the feedback signal in conventional systems, may be broken, which may decrease the DSM performance. However, in embodiments, the degradation of the performance may depend on how often the scalable DSM is reset, as shown in Fig. 9. Fig. 9 shows a plot of a Matlab simulation, wherein a 5 MHz LTE baseband signal at 860MHz sampling rate is fed into a fully digital TX composed of a first order DSM, a PWM and a PPM. The PWM has 16 amplitude levels and PPM has 64 phase positions. In embodiments, the less often the scalable DSM is reset, the better the scalable DSM may perform in terms of the quantization noise suppression. With a reset rate of every 4 samples 9006, in embodiments, the SNR may be improved by nearly 20dB. With a reset rate of every 64 samples 9010, in embodiments, the performance of the scalable DSM is almost as good as the conventional DSM 9002. Fig. 9 further shows graphs of the performance of embodiments of a scalable DSM reset every 8 samples 9008, and the performance without a DSM 9004. Without a DSM, each I/Q sample may be quantized sample by sample and hence quantization noise may be generated per each single sample. In embodiments, the I/Q signal may be quantized block by block, wherein each block may contain more than one sample. Moreover, the scalable DSM might not reduce the bandwidth of the DSM, as shown in Fig. 9 and Fig. 10. Fig. 10 shows a plot of the bandwidth of embodiments of a DSM for a conventional DSM 10002, without delta-sigma modulation 10004, a scalable DSM reset every 4 samples 10004, a scalable DSM reset every 8 samples 10008, and a scalable DSM reset every 64 samples 10010. The general shape of the DSM quantization noise may remain unchanged.

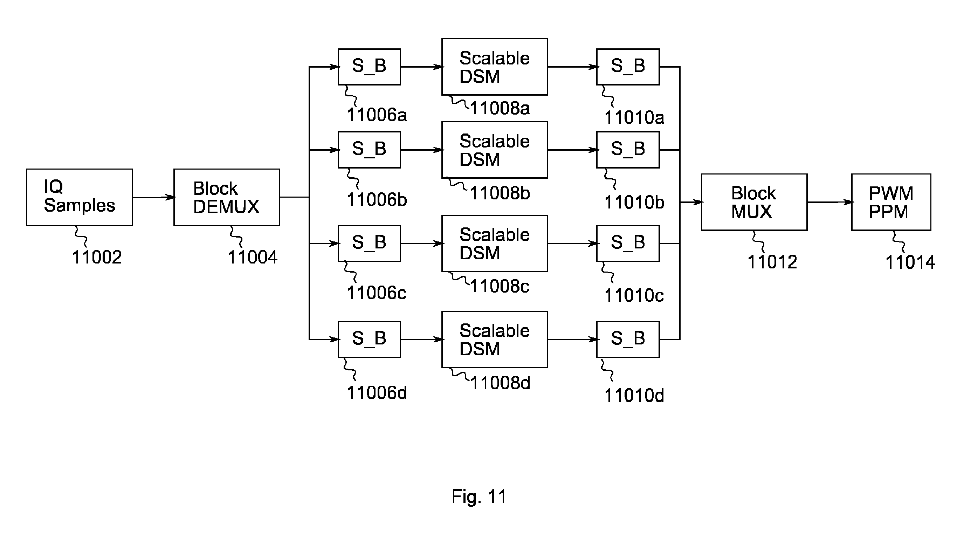

In embodiments, the scalable DSM may break the IIR loop comprising the feedback signal cyclically, so that the output signal may depend only on certain number of previous input samples, instead of all previous input samples. Consequently, the scalable DSM might be parallelized without significant performance loss, as illustrated in Fig. 11. In embodiments, the input IQ samples 11002 may be demultiplexed to parallel scalable DSMs 11008a-d block by block. Each data block, which may be buffered by input sample buffers 11006a-d and output sample buffers 11010a-d may contain a number of samples based on the number of samples per reset. In embodiments as shown in Fig. 11, the scalable DSMs between the block demultiplexer 11004 and block multiplexer 11012 may operate at a frequency that may correspond to a fourth of the I/Q data frequency. Fig. 11 further shows a PWM and PPM module 11014. In embodiments, the block demultiplexer 11004 may be coupled to the I/Q samples 11002 and the input sample buffers 11006a-d. The parallel scalable DSMs 11008a-d may be coupled to the respective input sample buffers 11006a-d and output sample buffers 11010a-d. The block multiplexer 11012 may be coupled to the output sample buffers 11010a-d and the PWM and PPM module 11014. Embodiments might further parallelize the scalable DSMs for further reduction of the DSM operating frequency. Embodiments may scale the DSM performance in terms of quantization noise suppression by changing the reset rate, and scale DSM operating rate by a parallelization of the scalable DSMs. In some embodiments, the scalable DSM might be 8-fold parallelized, such that the DSM operating frequency might be reduced by factor 8. A 2 GHz DSM might, in embodiments, be realized with 8 parallel scalable DSMs running at 250MHz, which might be implemented in an FPGA. With a reduced operating frequency, we more signal processing may be possible in the scalable DSM, such as a pre-distortion for a switch power amplifier.

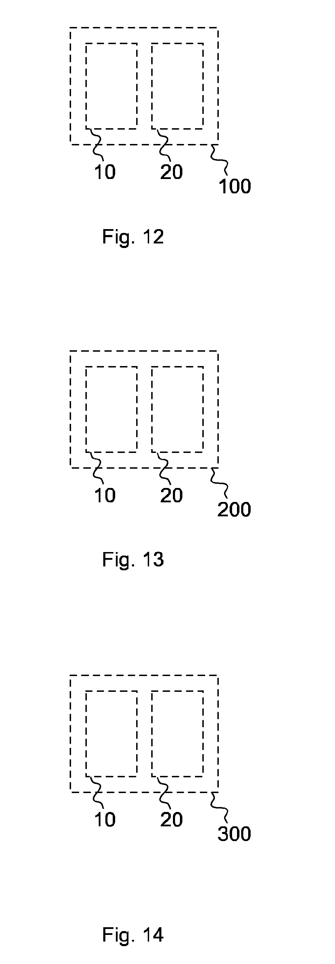

Fig. 12 illustrates a block diagram of an embodiment of a receiver module 100 comprising an apparatus 10 or an apparatus 20.

Fig. 13 illustrates a block diagram of an embodiment of a transmitter module 200 comprising an apparatus 10 or an apparatus 20.

Fig. 14 illustrates a block diagram of an embodiment of an analog-digital converter 300 comprising an apparatus 10 or an apparatus 20.

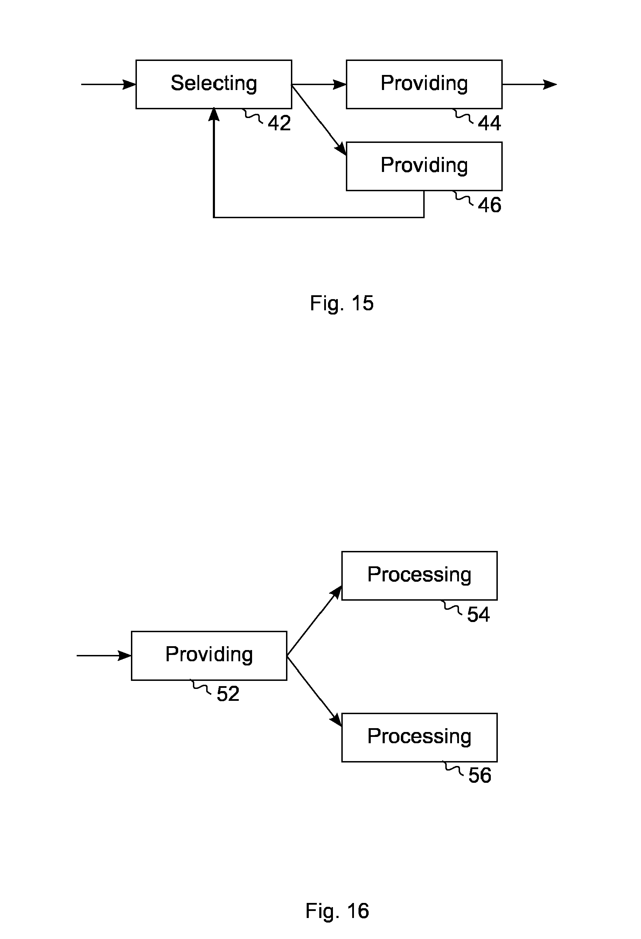

Fig. 15 shows a block diagram of a flow chart of an embodiment of a method for providing a delta-sigma-modulated signal, based on an input signal. The method comprises selecting 42 the input signal or a combined signal as selected signal, wherein the combined signal is based on a combination of the input signal, a feedback signal, and a reference signal. The method further comprises providing 44 the delta-sigma modulated signal representing a quantized selected signal based on a selected signal and providing 46 the feedback signal based on the selected signal.

Fig. 16 shows a block diagram of a flow chart of an embodiment of a method for processing a sampled signal with a primary sampling rate. The method comprises providing 52 a first input signal with a first sampling rate and a second input signal with a second sampling rate, wherein the first and second sampling rates are lower than the primary sampling rate, and wherein the first and second input signals are based on the sampled signal. The method further comprises processing 54 the first input signal according to claim 13 to provide a first delta-sigma-modulated signal and processing 56 the second input signal according to claim 13 to provide a second delta-sigma-modulated signal.

Some embodiments comprise a digital control circuit installed within the apparatus for performing the method. Such a digital control circuit, e.g. a Digital Signal Processor (DSP) or a Field Programmable Gate Array (FPGA) needs to be programmed accordingly. Hence, yet further embodiments also provide a computer program having a program code for performing embodiments of the method, when the computer program is executed on a computer, a digital processor, or a programmable hardware component. A further embodiment is a computer readable storage medium storing instructions which, when executed by a computer, processor, or programmable hardware component, cause the computer to implement one of the methods described herein.

Embodiments may provide a scalable DSM with a parallel structure. In embodiments, not only the DSM performance but also the operating frequency of the DSM might be independently optimized by changing the reset rate of the scalable DSM or by varying the degree of parallelization of the scalable DSM.

A time interleaved DSM might not be seen as a parallelization of a DSM, because the interleaved quantization error might have to be processed at the carrier frequency or at the primary sampling rate. Furthermore, without interleaving, the DSM performance, especially the DSM bandwidth may decrease. In at least some embodiments, the operating frequency of the scalable DSM might be arbitrarily scaled down by any factor, at, in at least some embodiments, no or minor deterioration of the bandwidth of the DSM, and with only slightly less noise filtering, which may depend on a reset rate.

A person of skill in the art would readily recognize that steps of various above-described methods can be performed by programmed computers. Herein, some embodiments are also intended to cover program storage devices, e.g., digital data storage media, which are ma-chine or computer readable and encode machine-executable or computer-executable pro-grams of instructions where said instructions perform some or all of the steps of methods described herein. The program storage devices may be, e.g., digital memories, magnetic storage media such as magnetic disks and magnetic tapes, hard drives, or optically readable digital data storage media. The embodiments are also intended to cover computers programmed to perform said steps of methods described herein or (field) programmable logic arrays ((F)PLAs) or (field) programmable gate arrays ((F)PGAs), programmed to perform said steps of the above-described methods.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements shown in the Figures, including any functional blocks labeled as "means", "means for controlling", "means for transmitting", "means for receiving", "means for transceiving", "means for processing", etc., may be provided through the use of dedicated hardware, such as "a controller", "a transmitter", "a receiver", "a transceiver", "a processor", etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional or custom, may also be included. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

## Claims

1. An apparatus (10) for providing a delta-sigma-modulated signal, based on an input signal, the apparatus (10) comprising
a combination module (12) to dynamically select the input signal or a combined signal as selected signal, wherein the combined signal is based on a combination of the input signal, a feedback signal, and a reference signal; and
a processing module (14) to provide the delta-sigma modulated signal representing a quantized selected signal based on the selected signal, and to provide the feedback signal based on the selected signal.

2. The apparatus (10) of claim 1 further comprising one or more additional combination modules (12a) corresponding to the combination module (12), wherein a selected signal of one of the one or more additional combination modules (12a) is used as input for a subsequent combination module (12, 12a), and/or further comprising one or more additional combination modules (12a) corresponding to the combination module (12), wherein a selected signal of one of the one or more additional combination modules (12a) is used as input for a subsequent combination module (12, 12a) and wherein the additional combination modules (12a) are configured to dynamically select the input signal or an additional combined signal, wherein the additional combined signal is further based on an additional feedback signal, and wherein the combination module (12) is configured to provide the additional feedback signal to one of the one or more additional combination modules (12a).

3. The apparatus (10) of claim 1, wherein the combination module (12) comprises a switch (12b) configured to switch an input (14a) of the processing module (14) for the selected signal between an input (12c) for the input signal and the combined signal and/or wherein the combination module (12) further comprises a buffer (12d) to store the selected signal and to provide the selected signal as previous selected signal subsequently and/or wherein the reference signal corresponds to a previously selected signal, a constant value or a reset value.

4. The apparatus (10) of claim 1, wherein the apparatus (10) further comprises a control module (18), and wherein the control module (18) is configured to control the combination module (12), and wherein the control module (18) is configured to determine information related to the selection for the combination module (12).

5. The apparatus (10) of claim 4, wherein the combination of the input signal, the feedback signal and the reference signal of the combination module (12) corresponds to a weighted combination, and wherein the control module (18) is further configured to determine information related to a weighting of the weighted combination and/or wherein a state of the apparatus (10) is based on a previous selected signal and the feedback signal, and wherein the control module (18) is configured to perform an iteration on the state of the apparatus (10), starting with an initial state, wherein the initial state corresponds to selecting the input signal, a constant value or a dynamical value as the selected signal, and wherein the control module (18) is further configured to select the combined signal as the selected signal until an end of the iteration, and wherein the end of the iteration is based on an integer number of iteration cycles.

6. The apparatus (10) of claim 4, wherein the input signal comprises a plurality of blocks of samples, wherein the control module (18) is configured to determine the information related to the selection for the combination module (12) based on information related to a number of samples in a block of the input signal, and/or wherein the control module (18) is configured to determine the information related to the selection for the combination module (12) based on information related to a number of processed samples since a last change of the selection for the combination module (12), and/or wherein the control module (18) is configured to determine the selection for the combination module (12) such that the input signal is selected as selected signal at least once within a block of samples, and/or wherein the control module (18) is configured to determine the information related to the selection for the combination module (12) based on a performance requirement.

7. The apparatus (10) of claim 1, wherein the processing module (14) further comprises a Look-Up Table, LUT, which is configured to assign samples of the delta-sigma-modulated signal to samples of the selected signal, and/or wherein the selected signal corresponds to a sequence of signal pulses or a pre-defined signal pattern.

8. An apparatus (20) for processing a sampled signal with a primary sampling rate, the apparatus (20) comprising
a demultiplexing module (22) to provide a first input signal with a first sampling rate, and a second input signal with a second sampling rate, wherein the first and second sampling rates are lower than the primary sampling rate, and wherein the first and second input signals are based on the sampled signal;
a first apparatus (10a) according to claim 1, to process the first input signal to provide a first delta-sigma-modulated signal; and
a second apparatus (10b) according to claim 1, to process the second input signal to provide a second delta-sigma-modulated signal.

9. The apparatus (20) of claim 8, wherein the demultiplexing module (22) further provides the first and second input signals as block-wise demultiplexed signals, and/or wherein the apparatus (20) further comprises a first and second input sample buffer (26a, 26b) to buffer the first and second input signals, and/or wherein the apparatus (20) comprises a first and a second output sample buffer (28a, 28b) to buffer the two or more delta-sigma-modulated signals, and/or wherein the apparatus (20) further comprises a multiplexing module (24) to provide a multiplexed signal, based on the first and second delta-sigma-modulated signals, and/or wherein the demultiplexing module (22) and/or the multiplexing module (24) comprise a buffer for storing the first or second input signals and/or the first and second delta-sigma-modulated signals.

10. The apparatus (20) of claim 9, wherein the apparatus (20) further comprises a pulse modulator (30) to provide a pulse modulated signal based on the multiplexed signal.

11. The apparatus (20) of claim 10, wherein the pulse modulator (30) comprises a Pulse Width Modulator, PWM, (30a), and/or wherein the pulse modulator (30) comprises a Pulse Position Modulator, PPM, (30b).

12. A receiver module (100), a transmitter module (200), and/or an analog-digital converter (300) comprising an apparatus (10) of claim 1 or an apparatus (20) of claim 8.

13. A method for providing a delta-sigma-modulated signal, based on an input signal, the method comprising
selecting (42) the input signal or a combined signal as selected signal, wherein the combined signal is based on a combination of the input signal, a feedback signal, and a reference signal;
providing (44) the delta-sigma modulated signal representing a quantized selected signal based on a selected signal; and
providing (46) the feedback signal based on the selected signal

14. A method for processing a sampled signal with a primary sampling rate, the method comprising
providing (52) a first input signal with a first sampling rate and a second input signal with a second sampling rate, wherein the first and second sampling rates are lower than the primary sampling rate, and wherein the first and second input signals are based on the sampled signal;
processing (54) the first input signal according to claim 13 to provide a first delta-sigma-modulated signal; and
processing (56) the second input signal according to claim 13 to provide a second delta-sigma-modulated signal.

15. A computer program having a program code for performing at least one of the methods of claim 13 and 14, when the computer program is executed on a computer, a processor, or a programmable hardware component.
